(19) Europäisches Patentamt
European Patent Office
Office européen des brevets

(11) **EP 4 050 355 A1**

(12) **EUROPÄISCHE PATENTANMELDUNG**

(43) Veröffentlichungstag:
**31.08.2022 Patentblatt 2022/35**

(21) Anmeldenummer: **22156915.5**

(22) Anmeldetag: **16.02.2022**

(51) Internationale Patentklassifikation (IPC):
**G01R 31/367** (2019.01)    **G01R 31/3842** (2019.01)
**G01R 31/389** (2019.01)

(52) Gemeinsame Patentklassifikation (CPC):
**G01R 31/3842; G01R 31/367; G01R 31/389**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(30) Priorität: **26.02.2021 DE 102021201857**

(71) Anmelder: **Siemens Mobility GmbH
81739 München (DE)**

(72) Erfinder: **Hassler, Stefan
91281 Kirchenthumbach, OT Neuzirkendorf (DE)**

(54) **SCHÄTZEINRICHTUNGEN UND VERFAHREN ZUM SCHÄTZEN DES BETRIEBSZUSTANDS EINER BATTERIE**

(57) Die Erfindung bezieht sich unter anderem auf eine Schätzeinrichtung (10) zum Schätzen des Betriebszustands einer Batterie (210). Diese ist erfindungsgemäß gekennzeichnet durch eine Batteriespannungsschätzeinrichtung (11), die unter Berücksichtigung eines den jeweiligen Batteriestrom angebenden Batteriestromwerts (I), eines geschätzten Innenwiderstandswert ($\hat{R}$) der Batterie (210) und eines geschätzten Ladezustandswerts ($\hat{S}$) der Batterie (210) die jeweilige Batterieklemmenspannung ($\hat{U}_{kl,k}$) schätzt, einen Differenzbildner (12), der die Differenz zwischen der geschätzten Batterieklemmenspannung ($\hat{U}_{kl,k}$) und einer tatsächlich gemessenen Batterieklemmenspannung $\tilde{U}_{kl,k}$, unter Bildung eines Differenzwerts ($\delta\tilde{U}_{kl,k}$) ermittelt, und eine Zustandsbeobachtungseinrichtung (13), die unter Berücksichtigung eines Fehlerzustandsraums und des Differenzwerts ($\delta\tilde{U}_{kl,k}$) des Differenzbildners (12) einen Widerstandskorrekturwert ($\hat{\delta R}$) und einen Ladezustandskorrekturwert ($\hat{\delta S}$) erzeugt und diese zu der Batteriespannungsschätzeinrichtung (11) übermittelt, wobei die Batteriespannungsschätzeinrichtung (11) nach Erhalt des Widerstandskorrekturwerts ($\hat{\delta R}$) auf dessen Basis die Schätzung des Innenwiderstands unter Bildung eines neu geschätzten Innenwiderstandswerts ($\hat{R}$) aktualisiert, nach Erhalt eines Ladezustandskorrekturwerts auf dessen Basis die Schätzung des Ladezustands unter Bildung eines neu geschätzten Ladezustandswerts ($\hat{S}$) aktualisiert und eine Neuschätzung der Batterieklemmenspannung ($\hat{U}_{kl,k}$) durchführt.

FIG 3

EP 4 050 355 A1

**Beschreibung**

Die Erfindung bezieht sich auf Schätzeinrichtungen und Verfahren zum Schätzen des Betriebszustands einer Batterie. Der Innenwiderstand und der Ladezustand einer Batterie sind wichtige Größen für deren Betrieb. Bei Einsatz einer Batterie als Traktionsbatterie in einem Fahrzeug ist eine kontinuierliche und möglichst exakte Bestimmung besonders des Ladezustands wünschenswert.

Eine exakte Messung des Ladezustands ist bei Batterien jedoch ausschließlich im abgeschalteten Zustand möglich. Erst nach einigen Minuten ohne Strom stellt sich an den Batterieklemmen die chemische Spannung ein, welche auch als "Open Circuit Voltage" bezeichnet wird. Für diese chemische Spannung kann - beispielsweise vor Inbetriebnahme der Batterie in einem Labor oder einer Fabrik - ein nichtlinearer funktionaler Zusammenhang zwischen Ladezustand und der jeweiligen chemischen Spannung ermittelt werden. Im Betrieb jedoch kann diese chemische Spannung an den Batterieklemmen nicht gemessen werden, da am Innenwiderstand der Batterie aufgrund des Batteriestromes ebenfalls ein Spannungsabfall auftritt, der sich zu der chemischen Spannung addiert. Da jedoch der Innenwiderstand ebenfalls in der Regel nicht exakt bekannt ist und in der Regel von der Temperatur und dem Ladezustand der Batterie abhängt, ist für eine Bestimmung des Ladezustands und des Innenwiderstands während des Betriebs eine Zustandsschätzung notwendig.

Der Erfindung liegt somit die Aufgabe zugrunde, zum Schätzen des Betriebszustands einer Batterie eine Schätzeinrichtung anzugeben, die möglichst exakte Schätzergebnisse liefert.

Diese Aufgabe wird erfindungsgemäß durch eine Einrichtung mit den Merkmalen gemäß Patentanspruch 1 gelöst. Vorteilhafte Ausgestaltungen der erfindungsgemäßen Einrichtung sind in Unteransprüchen angegeben.

Danach ist erfindungsgemäß vorgesehen eine Batteriespannungsschätzeinrichtung, die unter Berücksichtigung eines den jeweiligen Batteriestrom angebenden Batteriestromwerts, eines geschätzten Innenwiderstands der Batterie und eines geschätzten Ladezustands der Batterie die jeweilige Batterieklemmenspannung schätzt, ein Differenzbildner, der die Differenz zwischen der geschätzten Batterieklemmenspannung und einer tatsächlich gemessenen Batterieklemmenspannung unter Bildung eines Differenzwerts ermittelt, und eine Zustandsbeobachtungseinrichtung, die unter Berücksichtigung eines Fehlerzustandsraums und des Differenzwerts des Differenzbildners einen Widerstandskorrekturwert und einen Ladezustandskorrekturwert erzeugt und diese zur der Batteriespannungsschätzeinrichtung übermittelt, wobei die Batteriespannungsschätzeinrichtung nach Erhalt des Widerstandskorrekturwerts auf dessen Basis die Schätzung des Innenwiderstands unter Bildung eines neu geschätzten Innenwiderstandswerts aktualisiert, nach Erhalt eines Ladezustandskorrekturwerts auf dessen Basis die Schätzung des Ladezustands unter Bildung eines neu geschätzten Ladezustandswerts aktualisiert und eine Neuschätzung der Batterieklemmenspannung durchführt.

Ein wesentlicher Vorteil der erfindungsgemäßen Schätzeinrichtung ist darin zu sehen, dass auch bei hoher Stromdynamik eine gute Genauigkeit bezüglich der Schätzung des Ladezustands und des Innenwiderstands erreicht wird. Die eigentliche Stromdynamik wird im Batteriemodell berücksichtigt, so dass der gemessene Spannungsfehler nur eine sehr kleine Dynamik aufweist. Die im Fehlerzustandsraum arbeitende Zustandsbeobachtungseinrichtung ist somit ebenfalls nur mit einer sehr kleinen Dynamik konfrontiert, welche zu der Dynamik der zu schätzenden Parameter passt. Der Innenwiderstand ist in der Regel nämlich eine nahezu konstante Größe und der Ladezustand ändert sich mit einer deutlich kleineren Dynamik als der Strom. Die Arbeits- bzw. Tuning-Parameter der Zustandsbeobachtungseinrichtung können daher optimal auf die zu schätzenden Größen, also den Ladezustand und den Innenwiderstand, abgestimmt werden.

Ein weiterer wesentlicher Vorteil der erfindungsgemäßen Schätzeinrichtung ist darin zu sehen, dass durch die vorgeschlagene Rückkopplung die Abweichung zwischen den Modellparametern für den Ladezustand und den Innenwiderstand von den tatsächlichen Parametern sehr klein wird. Im Fehlerzustand kann daher die Abbildung vom angenommenen Ladezustand auf die Spannung durch eine linearisierte Funktion ersetzt werden. Der Linearisierungsfehler kann hierbei vernachlässigt werden.

Vorteilhaft ist es, wenn die Zustandsbeobachtungseinrichtung ein Optimalfilter im Fehlerzustandsraum ist oder ein solches zumindest auch enthält.

Als besonders vorteilhaft wird es angesehen, wenn die Zustandsbeobachtungseinrichtung ein Kalmanfilter, insbesondere ein Kalmanfilter im Fehlerzustandsraum, ist oder ein solches zumindest auch enthält.

Im Übrigen ist es vorteilhaft, wenn die Batteriespannungsschätzeinrichtung absolute Zustandsgrößen verarbeitet und die fehlerzustandsraumbezogene Zustandsbeobachtungseinrichtung und die absolute Zustandsgrößen verarbeitende Batteriespannungsschätzeinrichtung einen Bestandteil einer regelkreisartigen Rückkopplungsstruktur bilden.

Die Zustandsbeobachtungseinrichtung errechnet vorzugsweise auf der Basis einer Zustandsfehlerkovarianzmatrix eine Kalman-Gain-Matrix und bestimmt den Widerstandskorrekturwert und den Ladezustandskorrekturwert vorzugsweise unter Heranziehung der Kalman-Gain-Matrix.

Mit Blick auf die letztgenannte Ausgestaltung wird es außerdem als vorteilhaft angesehen, wenn der Widerstandskorrekturwert und der Ladezustandskorrekturwert Vektorkomponenten eines Fehlerzustandsvektors bilden und die Zustandsbeobachtungseinrichtung den Fehlerzustandsvektor durch Multiplikation der Kalman-Gain-Matrix und des Differenzwerts errechnet.

Der von der Zustandsbeobachtungseinrichtung berücksichtigte Fehlerraum wird vorzugsweise durch eine Zustandsfehlerkovarianzmatrix definiert oder zumindest mitdefiniert.

Die Batteriespannungsschätzeinrichtung, der Differenzbildner und die Zustandsbeobachtungseinrichtung bilden vorzugsweise eine geschlossene Regelschleife.

Bei der letztgenannten Ausgestaltung ist es vorteilhaft, wenn in jedem Schleifendurchlauf der geschlossenen Regelschleife

- die Zustandsbeobachtungseinrichtung nach Erhalt des Differenzwerts eine aktuelle Kalman-Gain-Matrix auf der Basis einer aktuellen Zustandsfehlerkovarianzmatrix berechnet, einen Fehlerzustandsvektor auf der Basis der aktuell berechneten Kalman-Gain-Matrix berechnet, die Zustandsfehlerkovarianzmatrix aktualisiert und den berechneten Fehlerzustandsvektor zur Batteriespannungsschätzeinrichtung übermittelt,
- die Batteriespannungsschätzeinrichtung nach Erhalt des Fehlerzustandsvektors die Schätzung des Innenwiderstands und die des Ladezustands aktualisiert und eine Neuschätzung der Batterieklemmenspannung durchführt und
- der Differenzbildner die Differenz zwischen der zuletzt geschätzten Batterieklemmenspannung und der aktuell tatsächlich gemessenen Batterieklemmenspannung unter Bildung eines neuen Differenzwerts für einen neuen Schleifendurchlauf ermittelt und diesen zu der Zustandsbeobachtungseinrichtung übermittelt.

Der von der Zustandsbeobachtungseinrichtung berücksichtigte Fehlerraum, insbesondere die Zustandsfehlerkovarianzmatrix, hängt vorzugsweise von einem, mehreren oder allen der nachfolgend genannten Werte ab:

- einem Standardabweichungswert, der unter Annahme eines Gauß-verteilten Rauschprozesses die Unsicherheit des Innenwiderstandswerts angibt,
- einem Standardabweichungswert, der unter Annahme eines Gauß-verteilten Rauschprozesses die Unsicherheit des Batteriestromwerts angibt,
- einem Varianzwert, der die Varianz des Fehlers des geschätzten Ladezustandswerts angibt,
- einem Varianzwert, der die Varianz des Fehlers der tatsächlich gemessenen Batterieklemmenspannung angibt,
- einem Varianzwert, der die Varianz des Gauß-verteilten Rauschprozesses des Batteriestromwerts angibt,
- einem Varianzwert, der die Varianz des Gauß-verteilten Rauschprozesses des Innenwiderstandswerts angibt,
- einer zeitlichen Korrelationszeit des Stromfehlers des Batteriestromwerts.

Die Erfindung bezieht sich darüber hinaus auf ein Fahrzeug, insbesondere Schienenfahrzeug, das mit einer Traktionsbatterie ausgestattet ist. Erfindungsgemäß ist bzgl. des Fahrzeugs vorgesehen, dass dieses eine Schätzeinrichtung aufweist, wie sie oben beschrieben worden ist und zum Schätzen des Betriebszustands der Traktionsbatterie geeignet ist.

Bezüglich der Vorteile und vorteilhafter Ausgestaltungen des erfindungsgemäßen Fahrzeugs sei auf die obigen Ausführungen im Zusammenhang mit der erfindungsgemäßen Schätzeinrichtung sowie deren vorteilhafter Ausgestaltungen verwiesen.

Die Erfindung bezieht sich darüber hinaus auf ein Verfahren zum Schätzen des Betriebszustands einer Batterie. Erfindungsgemäß ist vorgesehen, dass unter Berücksichtigung eines den Batteriestrom angebenden Batteriestromwerts, eines geschätzten Innenwiderstands und eines geschätzten Ladezustands die jeweilige Batterieklemmenspannung geschätzt wird, die Differenz zwischen der geschätzten Batterieklemmenspannung und der tatsächlich gemessenen Batterieklemmenspannung unter Bildung eines Differenzwerts ermittelt wird und unter Berücksichtigung eines Fehlerraums und des Differenzwerts ein Widerstandskorrekturwert und ein Ladezustandskorrekturwert erzeugt werden, wobei nach Vorliegen des Widerstandskorrekturwerts auf dessen Basis die Schätzung des Innenwiderstands unter Bildung eines neu geschätzten Innenwiderstandswerts aktualisiert wird, nach Vorliegen des Ladezustandskorrekturwerts auf dessen Basis die Schätzung des Ladezustands unter Bildung eines neu geschätzten Ladezustandswerts aktualisiert wird und eine Neuschätzung der Batterieklemmenspannung durchgeführt wird.

Bezüglich der Vorteile und vorteilhafter Ausgestaltungen des erfindungsgemäßen Verfahrens sei auf die obigen Ausführungen im Zusammenhang mit der erfindungsgemäßen Schätzeinrichtung sowie deren vorteilhafter Ausgestaltungen verwiesen.

Vorteilhaft ist es, wenn die Schätzung der Batterieklemmenspannung, die Differenzbildung und die Zustandsbeobachtung im Rahmen einer geschlossenen Regelschleife wiederholt werden.

Die Zustandsbeobachtung wird vorzugsweise im Fehlerzustandsraum durchgeführt.

Die Batteriespannungsschätzung beruht vorzugsweise auf einer Verarbeitung absoluter Zustandsgrößen.

Die fehlerzustandsraumbezogene Zustandsbeobachtung und die auf absoluten Zustandsgrößen bezogene Batteriespannungsschätzung werden vorzugsweise in einer regelkreisartigen Rückkopplungsstruktur wiederholt durchgeführt.

Die Zustandsbeobachtung wird vorzugsweise mit oder zumindest auch mit einem Kalmanfilter durchgeführt.

Die Erfindung wird nachfolgend anhand von Ausführungsbeispielen näher erläutert; dabei zeigen beispielhaft

Figur 1    ein Ausführungsbeispiel für eine erfindungsgemäße Schätzeinrichtung zum Schätzen des Betriebszustands einer Batterie,

Figur 2    eine bevorzugte Ausgestaltung der Schätzeinrichtung gemäß Figur 1 näher im Detail und

Figur 3    ein Ausführungsbeispiel für ein erfindungsgemäßes Schienenfahrzeug, das mit einer Traktionsbatterie und einer Schätzeinrichtung zum Schätzen des Betriebszustands der Traktionsbatterie ausgestattet ist.

In den Figuren werden der Übersicht halber für identische oder vergleichbare Komponenten stets dieselben Bezugszeichen verwendet.

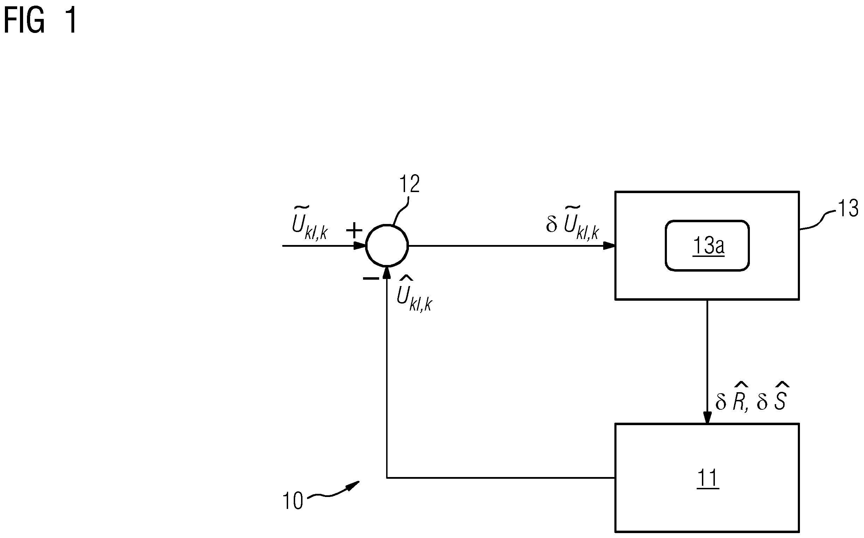

Die Figur 1 zeigt ein Ausführungsbeispiel für eine Schätzeinrichtung 10, die zum Schätzen des Betriebszustands einer Batterie, insbesondere einer Traktionsbatterie eines Schienenfahrzeugs, geeignet ist. Die Schätzeinrichtung 10 umfasst eine Batteriespannungsschätzeinrichtung 11, einen Differenzbildner 12 sowie eine Zustandsbeobachtungseinrichtung 13, die gemeinsam eine Regelschleife 14 bilden.

Die Aufgabe der Batteriespannungsschätzeinrichtung 11 besteht darin, unter Berücksichtigung eines den jeweiligen Batteriestrom angebenden Batteriestromwerts I zum Zeitpunkt k, eines geschätzten Innenwiderstands $\hat{R}$ der Batterie und eines geschätzten Ladezustands $\hat{S}$ der Batterie die jeweilige Batterieklemmenspannung $\hat{U}_{kl,k}$ zu schätzen: Zur Schätzung zieht die Batteriespannungsschätzeinrichtung 11 vorzugsweise das durch die folgenden zwei Gleichungen (1.1) und (1.2) definierte Batteriemodell heran:

$$\mathbf{z}_k^- = \begin{bmatrix} \hat{S} \\ \Delta\hat{I} \\ \hat{R} \end{bmatrix}_k^- = \left(\mathbf{I}^{3\times3} + \mathbf{A}_z \cdot T_s\right) \cdot \begin{bmatrix} \hat{S} \\ \Delta\hat{I} \\ \hat{R} \end{bmatrix}_{k-1}^+ + \mathbf{B} \cdot T_s \cdot I_k = \left(\mathbf{I}^{3\times3} + \begin{bmatrix} 0 & 0 & 0 \\ 0 & 0 & 0 \\ 0 & 0 & 0 \end{bmatrix} \cdot T_s\right) \cdot \begin{bmatrix} \hat{S} \\ \Delta\hat{I} \\ \hat{R} \end{bmatrix}_{k-1}^+ + \begin{bmatrix} \dfrac{1}{C_N} \\ 0 \\ 0 \end{bmatrix} \cdot T_s \cdot I_k$$

$$(1.1)$$

$$\hat{U}_{kl,k} = h\left(\hat{S}_k, \hat{R}_k, I_k\right) = U\left(\hat{S}_k\right) + \hat{R}_k \cdot I_k \qquad (1.2)$$

In den beiden obigen Formeln und den weiter unten noch folgenden Formeln bezeichnen die Formelzeichen Folgendes:

$C_N$       Nennkapazität der Batterie in z. B. Ah

$h(\hat{S}_k, \hat{R}_k, I_k)$       Nichtlineare Beobachtungsgleichung

$n_R$       Standardabweichung der Unsicherheit der Widerstandsschätzung (Annahme Gauß-verteilter Rauschprozess)

$n_I$       Standardabweichung der Unsicherheit der Stromschätzung (Annahme Gauß-verteilter Rauschprozess)

$\hat{R}$       Geschätzter Innenwiderstandswert

$\hat{S}$       Geschätzter Ladezustandswert

$T_s$       Samplezeit des Algorithmus

$\hat{U}_{kl,k}$       Geschätzte Batterieklemmenspannung zum Zeitpunkt k

$\tilde{U}_{kl,k}$       Gemessene Batterieklemmenspannung zum Zeitpunkt k

$\delta\tilde{U}_{kl,k}$       Abweichung bzw. Differenzwert zwischen modellbasierter Batterieklemmenspannung und tatsächlich gemessener Batterieklemmenspannung

$\hat{\delta I}$       Geschätzter Stromfehler

$\hat{\delta R}$       Widerstandskorrekturwert bzw. geschätzter Widerstandsfehler bzw. geschätzte Abweichung des Widerstands

$\hat{\delta S}$       Ladezustandskorrekturwert bzw. geschätzter Fehler bzw. geschätzte Abweichung des Ladezustands

$\tau_I$       Zeitliche Korrelationszeit des Stromfehlers

$\sigma_{\delta S}^2$       Varianz des Fehlers des Ladezustands

$\sigma^2_{n,I}$      strombezogene Varianz des Rauschprozess $n_I$,

$\sigma^2_{n,R}$      widerstandsbezogene Varianz des Rauschprozess $n_R$

$\sigma^2_{U,kl}$      Varianz des Fehlers der Spannungsmessung, z.B. aufgrund des Rauschens eines die Klemmenspannung messenden Spannungssensors

**A**$_z$      Systemmatrix Batteriemodell

**A**$_{\delta z}$      Systemmatrix des Fehlerzustandsraumes

B      Eingangsmatrix

**h**$^T$      Linearisierte Beobachtungsmatrix zwecks Abbildung der angenommenen Fehler auf die gemessene Spannungsabweichung

**I**$^{3\times3}$      Einheitsmatrix

**K**      Kalman-Gain-Matrix

**P**      Zustandsfehlerkovarianzmatrix

**R**      Unsicherheit des Spannungsfehlers

**Q**      Zustandsmodellunsicherheit

$\phi$      Hilfssystemmatrix

**z**$_k$      Zustandsvektor des Batteriemodells zum Zeitpunkt k

$\delta$**z**$_k$      Fehler- bzw. Abweichungszustandsvektor zum Zeitpunkt k

Der Differenzbildner 12 bildet aus der von der Batteriespannungsschätzeinrichtung 11 geschätzten Batterieklemmenspannung $\hat{U}_{kl,k}$ und der tatsächlich gemessenen Batterieklemmenspannung einen Differenzwert $\delta\tilde{U}_{kl,k}$, gemäß:

$$\delta\tilde{U}_{kl,k} = \tilde{U}_{kl,k} - \hat{U}_{kl,k} \qquad (1.3)$$

Die nachgeordnete Zustandsbeobachtungseinrichtung 13 umfasst ein Kalman-Filter 13a. Das Kalman-Filter 13a berücksichtigt ein Zustandsmodell der angenommenen Fehler (bzw. Abweichungen) und propagiert diese gemäß folgendem Dynamikmodell:

$$\delta\mathbf{z}_k^- = \begin{bmatrix} \delta\hat{S} \\ \delta\hat{I} \\ \delta\hat{R} \end{bmatrix}_k^- = \left(\mathbf{I}^{3\times3} + \mathbf{A}_{\delta z} \cdot T_s\right) \cdot \begin{bmatrix} \delta\hat{S} \\ \delta\hat{I} \\ \delta\hat{R} \end{bmatrix}_{k-1}^+ + \begin{bmatrix} 0 \\ n_I \\ n_R \end{bmatrix}_k \qquad (1.4)$$

Mit

$$\mathbf{A}_{\delta z} = \begin{bmatrix} 0 & 0 & \dfrac{1}{C_N} \\ \dfrac{\partial R(S)}{\delta S} & 0 & 0 \\ 0 & 0 & \dfrac{-1}{\tau_I} \end{bmatrix} \qquad (1.5)$$

Die propagierten Fehler werden durch die Messung der Spannungsabweichung korrigiert:

$$\delta\mathbf{z}_k^+ = \delta\mathbf{z}_k^- + \mathbf{K}_k \cdot \left(\tilde{U}_{kl,k} - \hat{U}_{kl,k}\right) = \delta\mathbf{z}_k^- + \mathbf{K}_k \cdot \left(\delta\tilde{U}_{kl,k}\right) \qquad (1.6)$$

$$\delta\tilde{U}_{kl,k} = \frac{\partial h\left(\hat{S}_k, \hat{R}_k, I_k\right)}{\partial \mathbf{z}^T} \cdot \delta\mathbf{z}_k^+ = \mathbf{h}^T \cdot \delta\mathbf{z}_k^+ = \left[\frac{\partial U\left(\hat{S}\right)}{\partial S} \quad \hat{R}_k \quad \hat{I}_k\right] \cdot \delta\mathbf{z}_k^+ \qquad (1.7)$$

Nach Eintreffen eines ersten Differenzwerts $\delta\tilde{U}_{kl,k}$ beim ersten Schleifendurchlauf der Regelschleife 14 berechnet die Zustandsbeobachtungseinrichtung 13 zunächst die Kalman-Gain Matrix $\mathbf{K}_k$ auf der Basis einer initialen Zustandsfehlerkovarianzmatrix $P_{k-1}^+$, die die angenommene Unsicherheit der Fehlerzustände zum Startzeitpunkt angibt, gemäß:

$$P_{k-1}^+ = \begin{bmatrix} \sigma_{\delta S}^2 & 0 & 0 \\ 0 & \sigma_{\delta I}^2 & 0 \\ 0 & 0 & \sigma_{\delta R}^2 \end{bmatrix} \qquad (1.8)$$

Durch die bereits erwähnte Propagation der Fehlerzustände werden auch die Fehler-Varianzen, die durch eine Zustandsfehlerkovarianzmatrix beschrieben werden können, propagiert; durch die Propagation wachsen die Fehler zu diesem Zeitschritt an:

$$\mathbf{P}_k^- = \mathbf{\Phi}_k \cdot \mathbf{P}_{k-1}^+ \cdot \mathbf{\Phi}_k^T + \mathbf{Q}_k \qquad (1.9)$$

Die Matrix Q beschreibt dabei die Zustandsmodellunsicherheit gemäß

$$\mathbf{Q}_k = \begin{bmatrix} 0 & 0 & 0 \\ 0 & \sigma_{n,I}^2 & 0 \\ 0 & 0 & \sigma_{n,R}^2 \end{bmatrix} \qquad (1.10)$$

und $\phi$ eine Hilfssystemmatrix auf der Basis der Systemmatrix des Fehlerzustandsraumes $\mathbf{A}_{\delta z}$ gemäß

$$\mathbf{\Phi} = \left(\mathbf{I}^{3 \times 3} + \mathbf{A}_{\delta z} \cdot T_s\right) \qquad (1.11)$$

Anschließend wird die Kalman-Gain-Matrix $\mathbf{K}$ berechnet:

$$\mathbf{K}_k = \mathbf{P}_k^- \cdot \mathbf{h}_k^T \cdot \left(\mathbf{h}_k \cdot \mathbf{P}_k^- \cdot \mathbf{h}_k^T + \mathbf{R}_k\right)^{-1} \qquad (1.12)$$

Die Matrix $\mathbf{R}_k$ beschreibt in obiger Gleichung die Unsicherheit des Spannungsfehlers, verursacht beispielsweise durch Rauschen in der Spannungsmessung:

$$\mathbf{R}_k = \sigma_{U,kl}^2 \qquad (1.13)$$

und $\mathbf{h}$ bezeichnet eine linearisierte Beobachtungsmatrix, die eine Abbildung der angenommenen Fehler auf die gemessene Spannungsabweichung durchführt.

Durch die Messung werden auch die Fehler bezüglich der geschätzten Zustände kleiner, also es werden mit anderen Worten die Schätzungen genauer, wodurch es zur Verkleinerung der Einträge in der Zustandsfehlerkovarianzmatrix $\mathbf{P}$ kommt; die Zustandsfehlerkovarianzmatrix $\mathbf{P}$ lässt sich anschließed wie folgt neu berechnen:

$$\mathbf{P}_k^+ = \left(\mathbf{I} - \mathbf{K}_k \cdot \mathbf{h}_k\right) \cdot \mathbf{P}_k^- \cdot \left(\mathbf{I} - \mathbf{K}_k \cdot \mathbf{h}_k\right)^T + \mathbf{K}_k \cdot \mathbf{R}_k \cdot \mathbf{K}_k^T \qquad (1.14)$$

Auch lassen sich die Fehlerzustände durch Verarbeitung der Messung korrigieren gemäß:

$$\delta \mathbf{z}_k^+ = \delta \mathbf{z}_k^- + \mathbf{K}_k \cdot \left( \tilde{U}_{kl,k} - \hat{U}_{kl,k} \right) = \delta \mathbf{z}_k^- + \mathbf{K}_k \cdot \left( \delta \tilde{U}_{kl,k} \right) \qquad (1.15)$$

Anschließend werden die neu geschätzten Fehlerzustände $\delta \mathbf{z}$, also auch der darin enthaltene Ladezustands-korrekturwert $\hat{\delta S}$ und der Widerstandskorrekturwerts $\hat{\delta R}$, zwecks Bildung der Regelschleife 14 und Ermittlung des neuen Zustandsvektors $\mathbf{z}$ zur Batterieschätzeinrichtung 11 zurückgekoppelt

$$\mathbf{z}_k^+ = \mathbf{z}_k^- + \delta \mathbf{z}_k^+ \qquad (1.16),$$

so dass die Batteriespannungsschätzeinrichtung 11 auf der Basis der obigen Gleichungen (1.1) und (1.2) erneut die Batterieklemmenspannung schätzen kann:

$$\hat{U}_{kl,k+1} = h\left( \hat{S}_{k+1}, \hat{R}_{k+1}, I_{k+1} \right) = U\left( \hat{S}_{k+1} \right) + \hat{R}_{k+1} \cdot I_{k+1} \qquad (1.17)$$

Die Fehlerzustände werden in der Zustandsbeobachtungseinrichtung 13 für den jeweils nächsten Schleifen-durchlauf vorzugsweise zurückgesetzt gemäß

$$\delta z_k^+ = 0 \qquad (1.18)$$

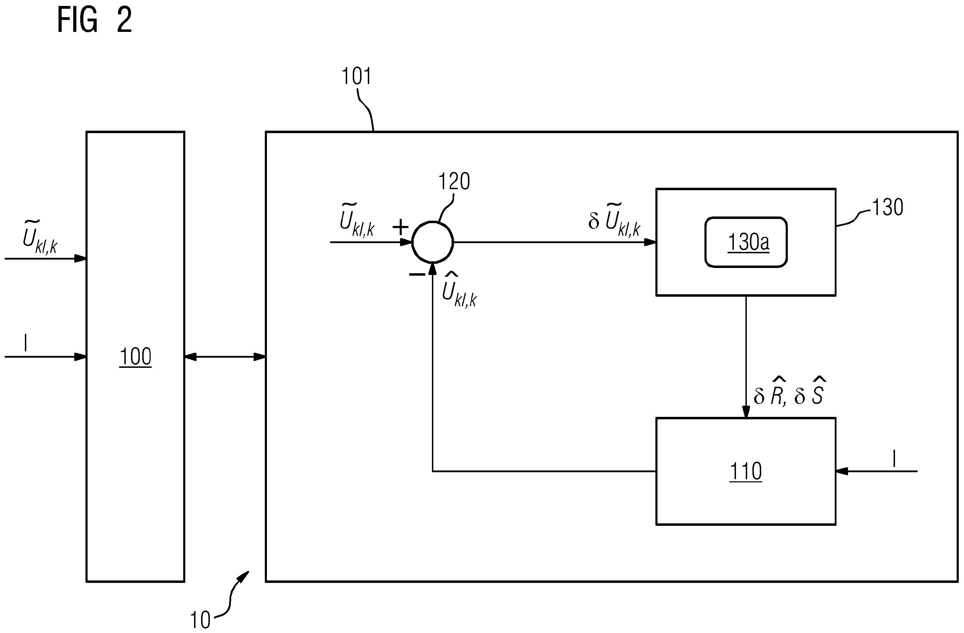

Die Figur 2 zeigt ein Ausführungsbeispiel für einen möglichen Aufbau der Einrichtung 10 gemäß Figur 1 näher im Detail. Man erkennt eine Recheneinrichtung 100, die mit einem Speicher 101 in Verbindung steht. In dem Speicher 101 sind ein Schätzsoftwaremodul 110, ein Differenzbildnersoftwaremodul 120 und ein Zustandsbeobachtungssoftwaremodul 130 abgespeichert. Das Zustandsbeobachtungsmodul 130 enthält ein Kalman-Filter-Modul 130a.

Werden die genannten Software 110, 120, 130 und 13a von der Recheneinrichtung 100 ausgeführt, so bildet die Recheneinrichtung die Batteriespannungsschätzeinrichtung 11, den Differenzbildner 12 sowie die Zustandsbeobachtungseinrichtung 13, wie sie oben im Zusammenhang mit der Figur 1 im Detail erläutert worden sind. Diesbezüglich gelten die obigen Ausführungen im Zusammenhang mit der Figur 1 entsprechend.

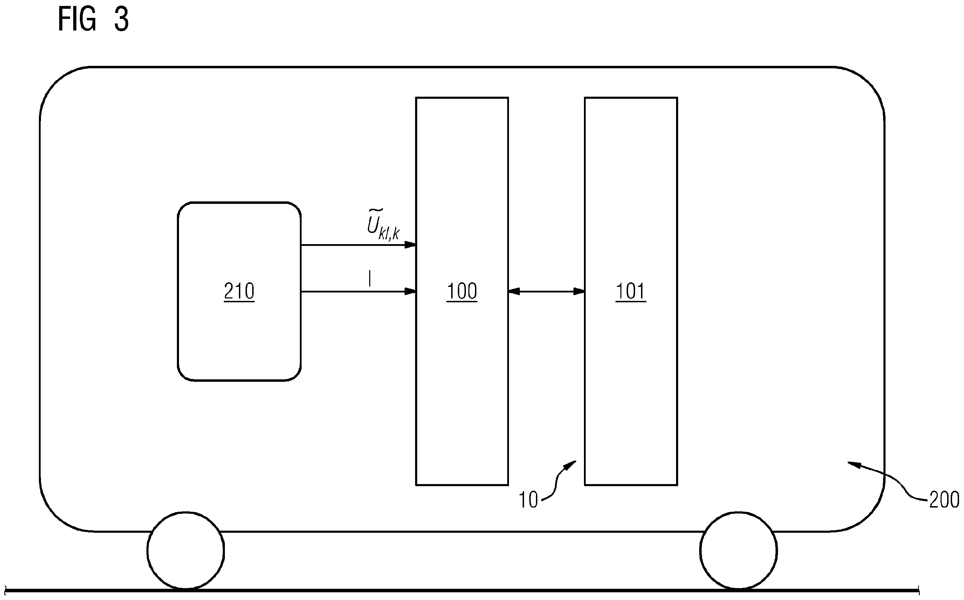

Die Figur 3 zeigt ein Ausführungsbeispiel für ein Schienenfahrzeug 200, dass mit einer Traktionsbatterie 210 ausgestattet ist. Zum Schätzen des Betriebszustands der Traktionsbatterie 210 dient eine Schätzeinrichtung 10, wie sie oben im Zusammenhang mit der Figur 1 erläutert worden ist. Die Schätzeinrichtung 10 kann durch eine Recheneinrichtung 100 und einen Speicher 101 gebildet werden, wie sie im Zusammenhang mit der Figur 2 erläutert worden sind.

Im Übrigen gelten die obigen Ausführungen im Zusammenhang mit den Figuren 1 und 2 für das Schienenfahrzeug 200 gemäß Figur 3 entsprechend.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1.  Schätzeinrichtung (10) zum Schätzen des Betriebszustands einer Batterie (210),
    **gekennzeichnet durch**

    - eine Batteriespannungsschätzeinrichtung (11), die unter Berücksichtigung eines den jeweiligen Batteriestrom angebenden Batteriestromwerts ($I$), eines geschätzten Innenwiderstandswert ($\hat{R}$) der Batterie (210) und eines geschätzten Ladezustandswerts ($\hat{S}$) der Batterie (210) die jeweilige Batterieklemmenspannung ($\hat{U}_{kl,k}$) schätzt,
    - einen Differenzbildner (12), der die Differenz zwischen der geschätzten Batterieklemmenspannung ($\hat{U}_{kl,k}$) und einer tatsächlich gemessenen Batterieklemmenspannung $\tilde{U}_{kl,k}$ unter Bildung eines Differenzwerts ($\delta \tilde{U}_{kl,k}$) er-mittelt, und
    - eine Zustandsbeobachtungseinrichtung (13), die unter Berücksichtigung eines Fehlerzustandsraums und des Differenzwerts ($\delta \tilde{U}_{kl,k}$) des Differenzbildners (12) einen Widerstandskorrekturwert ($\hat{\delta R}$) und einen Ladezustands-korrekturwert ($\hat{\delta S}$) erzeugt und diese zu der Batteriespannungsschätzeinrichtung (11) übermittelt,
    - wobei die Batteriespannungsschätzeinrichtung (11) nach Erhalt des Widerstandskorrekturwerts ($\hat{\delta R}$) auf des-

sen Basis die Schätzung des Innenwiderstands unter Bildung eines neu geschätzten Innenwiderstandswerts ($\hat{R}$) aktualisiert, nach Erhalt eines Ladezustandskorrekturwerts auf dessen Basis die Schätzung des Ladezustands unter Bildung eines neu geschätzten Ladezustandswerts ($\hat{S}$) aktualisiert und eine Neuschätzung der Batterieklemmenspannung ($\hat{U}_{kl,k}$) durchführt.

2. Schätzeinrichtung (10) nach Anspruch 1,
**dadurch gekennzeichnet, dass**

- die Zustandsbeobachtungseinrichtung (13) ein Optimalfilter im Fehlerzustandsraum ist oder ein solches zumindest auch enthält,
- die Batteriespannungsschätzeinrichtung (11) absolute Zustandsgrößen verarbeitet und
- die fehlerzustandsraumbezogene Zustandsbeobachtungseinrichtung (13) und die absolute Zustandsgrößen verarbeitende Batteriespannungsschätzeinrichtung (11) einen Bestandteil einer regelkreisartigen Rückkopplungsstruktur bilden.

3. Schätzeinrichtung (10) nach einem der voranstehenden Ansprüche,
**dadurch gekennzeichnet, dass** die Zustandsbeobachtungseinrichtung (13) ein Kalmanfilter (13a), insbesondere ein Kalmanfilter (13a) im Fehlerzustandsraum, ist oder ein solches zumindest auch enthält.

4. Schätzeinrichtung (10) nach einem der voranstehenden Ansprüche,
**dadurch gekennzeichnet, dass** die Zustandsbeobachtungseinrichtung (13) auf der Basis einer Zustandsfehlerkovarianzmatrix (P) eine Kalman-Gain-Matrix (K) errechnet und den Widerstandskorrekturwert ($\delta\hat{R}$) und den Ladezustandskorrekturwert ($\delta\hat{S}$) unter Heranziehung der Kalman-Gain-Matrix (K) bestimmt.

5. Schätzeinrichtung (10) nach einem der voranstehenden Ansprüche,
**dadurch gekennzeichnet, dass**

- der Widerstandskorrekturwert ($\hat{R}$) und der Ladezustandskorrekturwert ($\hat{S}$) Vektorkomponenten eines Fehlerzustandsvektors (z) bilden und
- die Zustandsbeobachtungseinrichtung (13) den Fehlerzustandsvektor (z) durch Multiplikation der Kalman-Gain-Matrix (K) und des Differenzwerts ($\delta\tilde{U}_{kl,k}$) errechnet.

6. Schätzeinrichtung (10) nach einem der voranstehenden Ansprüche,
**dadurch gekennzeichnet, dass** der von der Zustandsbeobachtungseinrichtung (13) berücksichtigte Fehlerraum durch eine Zustandsfehlerkovarianzmatrix (P) definiert oder zumindest mitdefiniert wird.

7. Schätzeinrichtung (10) nach einem der voranstehenden Ansprüche,
**dadurch gekennzeichnet, dass** die Batteriespannungsschätzeinrichtung (11), der Differenzbildner (12) und die Zustandsbeobachtungseinrichtung (13) eine geschlossene Regelschleife (14) als regelkreisartige Rückkopplungsstruktur bilden.

8. Schätzeinrichtung (10) nach Anspruch 7,
**dadurch gekennzeichnet, dass** in jedem Schleifendurchlauf der geschlossenen Regelschleife (14)

- die Zustandsbeobachtungseinrichtung (13) nach Erhalt des Differenzwerts ($\delta\tilde{U}_{kl,k}$) eine aktuelle Kalman-Gain-Matrix (K) auf der Basis einer aktuellen Zustandsfehlerkovarianzmatrix (P) berechnet, einen Fehlerzustandsvektor (z) auf der Basis der aktuell berechneten Kalman-Gain-Matrix (K) berechnet, die Zustandsfehlerkovarianzmatrix (P) aktualisiert und den berechneten Fehlerzustandsvektor (z) zur Batteriespannungsschätzeinrichtung (11) übermittelt,
- die Batteriespannungsschätzeinrichtung (11) nach Erhalt des Fehlerzustandsvektors (z) die Schätzung des Innenwiderstands ($\hat{R}$) und die des Ladezustands ($\hat{S}$) aktualisiert und eine Neuschätzung der Batterieklemmenspannung durchführt und
- der Differenzbildner (12) die Differenz zwischen der zuletzt geschätzten Batterieklemmenspannung ($\hat{U}_{kl,k}$) und der aktuell tatsächlich gemessenen Batterieklemmenspannung ($\overset{\circ}{U}_{kl,k}$) unter Bildung eines neuen Differenzwerts ($\delta\tilde{U}_{kl,k}$) für einen neuen Schleifendurchlauf (14) ermittelt und diesen zu der Zustandsbeobachtungseinrichtung (13) übermittelt.

9. Schätzeinrichtung (10) nach einem der voranstehenden Ansprüche,

**dadurch gekennzeichnet, dass** der von der Zustandsbeobachtungseinrichtung (13) berücksichtigte Fehlerraum, insbesondere die Zustandsfehlerkovarianzmatrix (P), von einem, mehreren oder allen der nachfolgend genannten Werte abhängt:

- einem Standardabweichungswert ($n_R$), der unter Annahme eines Gauß-verteilten Rauschprozesses die Unsicherheit des Innenwiderstandswerts ($\hat{R}$) angibt,
- einem Standardabweichungswert ($n_l$), der unter Annahme eines Gauß-verteilten Rauschprozesses die Unsicherheit des Batteriestromwerts (I) angibt,

- einem Varianzwert $\left( \sigma_{\delta S}^2 \right)$, der die Varianz des Fehlers des geschätzten Ladezustandswerts ($\hat{S}$) angibt,

- einem Varianzwert $\left( \sigma_{U,kl}^2 \right)$, der die Varianz des Fehlers der tatsächlich gemessenen Batterieklemmenspannung angibt,

- einem Varianzwert $\left( \sigma_{n,l}^2 \right)$, der die Varianz des Gauß-verteilten Rauschprozesses des Batteriestromwerts (I) angibt,

- einem Varianzwert $\left( \sigma_{n,R}^2 \right)$, der die Varianz des Gauß-verteilten Rauschprozesses des Innenwiderstandswerts ($\hat{R}$) angibt,
- einer zeitlichen Korrelationszeit (Ts) des Stromfehlers des Batteriestromwerts (I).

10. Fahrzeug, insbesondere Schienenfahrzeug (200), das mit einer Traktionsbatterie (210) ausgestattet ist,
**dadurch gekennzeichnet, dass** das Fahrzeug eine Schätzeinrichtung (10) nach einem der voranstehenden Ansprüche aufweist, die den Betriebszustand der Traktionsbatterie (210) schätzt.

11. Verfahren zum Schätzen des Betriebszustands einer Batterie (210),
**dadurch gekennzeichnet, dass**

- unter Berücksichtigung eines den Batteriestrom angebenden Batteriestromwerts (I), eines geschätzten Innenwiderstandswerts ($\hat{R}$) und eines geschätzten Ladezustandswerts ($\hat{S}$) die jeweilige Batterieklemmenspannung ($\hat{U}_{kl,k}$) geschätzt wird,
- die Differenz zwischen der geschätzten Batterieklemmenspannung ($\hat{U}_{kl,k}$) und der tatsächlich gemessenen Batterieklemmenspannung ($\tilde{U}_{kl,k}$) unter Bildung eines Differenzwerts ($\delta U_{kl,k}$) ermittelt wird und
- unter Berücksichtigung eines Fehlerraums und des Differenzwerts ($\tilde{U}_{kl,k}$) ein Widerstandskorrekturwert ($\delta \hat{R}$) und ein Ladezustandskorrekturwert ($\delta \hat{S}$) erzeugt werden,
- wobei nach Vorliegen des Widerstandskorrekturwerts ($\delta \hat{R}$) auf dessen Basis die Schätzung des Innenwiderstands unter Bildung eines neu geschätzten Innenwiderstandswerts ($\hat{R}$) aktualisiert wird, nach Vorliegen des Ladezustandskorrekturwerts ($\delta \hat{S}$) auf dessen Basis die Schätzung des Ladezustands unter Bildung eines neu geschätzten Ladezustandswerts ($\hat{S}$) aktualisiert wird und eine Neuschätzung der Batterieklemmenspannung ($\hat{U}_{kl,k}$) durchgeführt wird.

12. Verfahren nach Anspruch 11,
**dadurch gekennzeichnet, dass** die Schätzung der Batterieklemmenspannung ($\hat{U}_{kl,k}$), die Differenzbildung und die Zustandsbeobachtung im Rahmen einer geschlossenen Regelschleife (14) wiederholt werden.

13. Verfahren nach einem der voranstehenden Ansprüche 11 bis 12,
**dadurch gekennzeichnet, dass**

- die Zustandsbeobachtung im Fehlerzustandsraum durchgeführt wird,
- die Batteriespannungsschätzung auf einer Verarbeitung absoluter Zustandsgrößen beruht und
- die fehlerzustandsraumbezogene Zustandsbeobachtung und die auf absoluten Zustandsgrößen bezogene Batteriespannungsschätzung in einer regelkreisartigen Rückkopplungsstruktur wiederholt durchgeführt werden.

14. Verfahren nach einem der voranstehenden Ansprüche 11 bis 13,
**dadurch gekennzeichnet, dass** die Zustandsbeobachtung mit oder zumindest auch mit einem Kalmanfilter (13a) durchgeführt wird.

FIG 1

FIG 2

EP 4 050 355 A1

## FIG 3

EP 4 050 355 A1

Europäisches
Patentamt

European
Patent Office

Office européen
des brevets

**EUROPÄISCHER RECHERCHENBERICHT**

**Nummer der Anmeldung**

**EP 22 15 6915**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 699 09 472 T2 (TOYOTA MOTOR CO LTD [JP]) 27. Mai 2004 (2004-05-27) * das ganze Dokument * ----- | 1-14 | INV. G01R31/367 G01R31/3842 G01R31/389 |
| X | US 2015/046108 A1 (AKAMINE NAOSHI [JP]) 12. Februar 2015 (2015-02-12) * Absätze [0034] - [0048]; Abbildungen 1-3 * ----- | 1-14 | |
| A | US 2017/356964 A1 (HEIRIES VINCENT [FR] ET AL) 14. Dezember 2017 (2017-12-14) * Absätze [0041] - [0110]; Abbildungen 1-10 * ----- | 1-14 | |
| A | DE 10 2004 035858 A1 (BOSCH GMBH ROBERT [DE]) 16. Februar 2006 (2006-02-16) * Absätze [0017] - [0031]; Abbildung 1 * ----- | 1-14 | |

RECHERCHIERTE SACHGEBIETE (IPC)

G01R

Der vorliegende Recherchenbericht wurde für alle Patentansprüche erstellt

| Recherchenort | Abschlußdatum der Recherche | Prüfer |
|---|---|---|
| München | 20. Juni 2022 | Maric, Viktor |

**ANHANG ZUM EUROPÄISCHEN RECHERCHENBERICHT
ÜBER DIE EUROPÄISCHE PATENTANMELDUNG NR.**

EP 22 15 6915

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-06-2022

| Im Recherchenbericht angeführtes Patentdokument | Datum der Veröffentlichung | Mitglied(er) der Patentfamilie | Datum der Veröffentlichung |
|---|---|---|---|
| DE 69909472 T2 | 27-05-2004 | CA 2333619 A1 | 02-12-1999 |
| | | CN 1311860 A | 05-09-2001 |
| | | DE 69909472 T2 | 27-05-2004 |
| | | EP 1081499 A1 | 07-03-2001 |
| | | ES 2197638 T3 | 01-01-2004 |
| | | JP 3873623 B2 | 24-01-2007 |
| | | KR 20010043872 A | 25-05-2001 |
| | | US 6285163 B1 | 04-09-2001 |
| | | WO 9961929 A1 | 02-12-1999 |
| US 2015046108 A1 | 12-02-2015 | JP 5798067 B2 | 21-10-2015 |
| | | JP 2013190274 A | 26-09-2013 |
| | | US 2015046108 A1 | 12-02-2015 |
| | | WO 2013136559 A1 | 19-09-2013 |
| US 2017356964 A1 | 14-12-2017 | CN 107110915 A | 29-08-2017 |
| | | EP 3224634 A1 | 04-10-2017 |
| | | FR 3029296 A1 | 03-06-2016 |
| | | JP 6712594 B2 | 24-06-2020 |
| | | JP 2017539060 A | 28-12-2017 |
| | | KR 20170088424 A | 01-08-2017 |
| | | US 2017356964 A1 | 14-12-2017 |
| | | WO 2016083753 A1 | 02-06-2016 |
| DE 102004035858 A1 | 16-02-2006 | DE 102004035858 A1 | 16-02-2006 |
| | | EP 1774351 A1 | 18-04-2007 |
| | | US 2009048793 A1 | 19-02-2009 |
| | | WO 2006010659 A1 | 02-02-2006 |

EPO FORM P0461

Für nähere Einzelheiten zu diesem Anhang : siehe Amtsblatt des Europäischen Patentamts, Nr.12/82